(19) Europäisches Patentamt
European Patent Office
Office européen des brevets

(11) **EP 3 520 149 B1**

# (12) EUROPEAN PATENT SPECIFICATION

(45) Date of publication and mention
of the grant of the patent:
**20.10.2021 Bulletin 2021/42**

(21) Application number: **17781198.1**

(22) Date of filing: **28.09.2017**

(51) Int Cl.:
*H01L 35/34* *(2006.01)*    *G01R 31/26* *(2020.01)*

(86) International application number:
**PCT/IL2017/051091**

(87) International publication number:
**WO 2018/061001 (05.04.2018 Gazette 2018/14)**

## (54) THERMOELECTRIC DEVICE

THERMOELEKTRISCHE VORRICHTUNG

DISPOSITIF THERMOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.09.2016 IL 24811516**

(43) Date of publication of application:
**07.08.2019 Bulletin 2019/32**

(60) Divisional application:
**21163282.3 / 3 855 517**

(73) Proprietor: **Yeda Research and Development Co.,
Ltd.
7610002 Rehovot (IL)**

(72) Inventors:
• **IMRY, Yoseph
6468210 Tel Aviv (IL)**
• **SHAHAR, Dan
7610002 Rehovot (IL)**

(74) Representative: **Pearl Cohen Zedek Latzer Baratz
UK LLP
The Gridiron Building
One Pancras Square
London N1C 4AG (GB)**

(56) References cited:
WO-A1-2013/035100    CN-A- 101 504 439
CN-U- 202 581 241    KR-A- 20140 127 056
US-A1- 2003 218 464    US-A1- 2013 042 900

• PIPE K P ET AL: "Bias-dependent Peltier
coefficient and internal cooling in bipolar
devices", PHYSICAL REVIEW, B. CONDENSED
MATTER, AMERICAN INSTITUTE OF PHYSICS.
NEW YORK, US, vol. 66, no. 12, 15 September
2002 (2002-09-15), page 125316.1, XP002341889,
ISSN: 0163-1829, DOI:
10.1103/PHYSREVB.66.125316

## Description

### FIELD OF THE INVENTION

This invention is related to thermoelectric devices based on diodes. Devices and systems of this invention can be used as cooling devices or cooling systems or as energy harvesting devices or energy harvesting systems.

### BACKGROUND OF THE INVENTION

There exists a significant interest in energy-conversion devices, e.g. either converting thermal (i.e. associated with temperature differences) to fully useful electrical energy, or the opposite process of investing electrical energy in making heat flow from a cool to a warm body, i.e. cooling. Both processes are obviously subject to the limitations imposed by thermodynamics. CN101504439 describes a diode characteristics tester for acquiring multiple voltage/current data at constant diode temperatures. The diode temperature is kept constant during measurement using a thermostat. CN202581241 U describes a mobile power source comprising a led lamp and a thermometer for checking the temperature. Pipe K.P. et al. Phys. Rev. B. 66, 125316, 2002 1-11 present a theoretical model for evaluation of thermoelectric phenomena in bipolar semiconductors and p-n junctions. The bipolar devices are modeled by introducing a bias-dependent Peltier coefficient at interfaces that takes into account the variation of the carrier's average transport energy. KR20140127056 describes a tester for a thermoelectric device, the tester applies voltage to the device and measures the internal resistance and temperature values of the device. US 2003/0218464 describes a test structure for testing a thick film thermoelectric device. The test structure is able to test the thermoelectric device in the device's three modes of operation, namely as a cooling device, as a heat pump and as a power generator. The test structure includes a current electrode blocks and thermocouples.

### SUMMARY OF THE INVENTION

In one embodiment, this invention provides a system according to claim 1 comprising:

- a diode comprising a cathode and an anode;
- at least one thermometer connected to said cathode or connected to said anode; and
- a power supply or a current generator; wherein:
- said power supply or said current generator is connected to leads, said leads provide current/voltage to said diode;
- said diode is operated under either reverse or forward bias;
- and wherein:

   said system further comprises a controller configured to:

   - receive a desired temperature value for said cathode or for said anode;
   - receive a measured temperature value from said thermometer for said cathode or for said anode;
   - determine a voltage/current level to be applied to the diode based on the measured temperature value in order to achieve said desired temperature value at said cathode or at said anode; and

   apply said determined voltage/current to said diode.

In one embodiment, this invention provides a method of changing the temperature of an element, according to claim 5, said method comprising:

▪ providing a system comprising:

- a diode comprising a cathode and an anode;
- a first thermometer attached to said cathode or to said anode; and
- a power supply or a current generator; wherein:
- said power supply or said current generator is connected to leads, said leads provide current/voltage to said diode;
- said diode is operated under either reverse or forward bias;
- contacting said cathode or said anode to said element;
- driving current through or applying voltage to said diode, thereby transferring heat between said element and said diode, thus changing the temperature of said element, wherein said system further comprising a controller configured to:
- receive a desired temperature value for said cathode or for said anode;

- receive a measured temperature value from said first thermometer for said cathode or for said anode;
- determine a voltage/current level to be applied to the diode based on the difference between said measured temperature and said desired temperature value; and
- apply said determined voltage/current.

**BRIEF DESCRIPTION OF THE DRAWINGS**

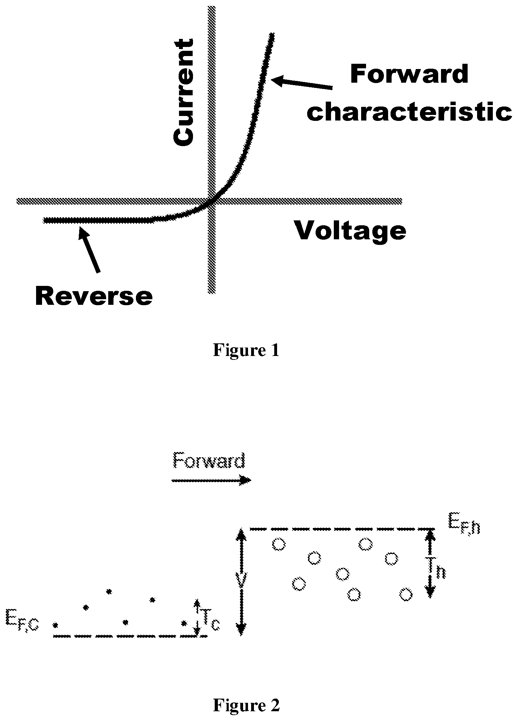

Figure 1 is a schematic I-V characteristic of a rectifier diode.

Figure 2 illustrates the principles of one embodiment of a system of this invention. The rectifier allows mostly electron flow from left (c-cold) to right (h-hot). It is reverse-biased: the Fermi level on the left is lower than the one on the right by $V \gg T$. The electrons on the left go to holes on the right, above a barrier (of height $W_F$, not shown) between the n and the p contacts, thereby cooling c. Each transported electron has to take an energy $W_F$ from the cool side and deliver it to the warm one. The Forward arrow shows the direction of electron flow in this embodiment.

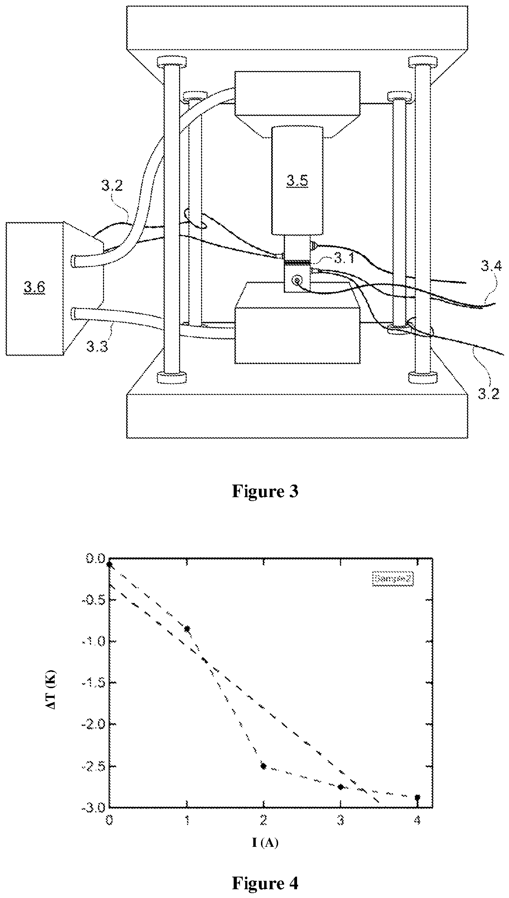

Figure 3 illustrates thermoelectric cooling across a two terminal Schottky diode. The image is a representation of the actual experiment. The various elements shown are as follows: 3.1 is a diode, in this embodiment attached with Ag-paint between two copper bars; 3.2 are thermocouples to read $\Delta T$; 3.3 are current leads; 3.4 are voltage probes to read $\Delta V$; the probes can be attached to a voltage reader/meter (not shown); 3.5 is an external heater; 3.6 is a power supply. The thermocouples can be attached to a temperature measuring device (not shown).

Figure 4 shows the developed temperature difference as a function of current through the device, graph presented with linear fit.

It will be appreciated that for simplicity and clarity of illustration, elements shown in the figures have not necessarily been drawn to scale. For example, the dimensions of some of the elements may be exaggerated relative to other elements for clarity. Further, where considered appropriate, reference numerals may be repeated among the figures to indicate corresponding or analogous elements.

**DETAILED DESCRIPTION OF THE PRESENT INVENTION**

In the following detailed description, numerous specific details are set forth in order to provide a thorough understanding of the invention. However, it will be understood by those skilled in the art that the present invention may be practiced without these specific details. In other instances, well-known methods, procedures, and components have not been described in detail so as not to obscure the present invention.

In one embodiment this invention provides a thermoelectric system, capable of cooling or heating an element. The system is based on an appropriate rectifier operated under either reverse or forward bias, V. The rectifier is shown to be able to cool by transferring heat between a cold terminal (at temperature $T_c$) and a hot terminal (at temperature $T_h$). Neglecting return currents and phonon parasitic thermal conductance, the efficiency is found to reach $W_F/V$, where $W_F$ is the barrier the electron has to cross in the forward direction. This is rather high, especially for such a simple device. The cooling power is $W_F I$, I being the current. A way to reduce the phonon thermal conductance is suggested.

As far as the negative effect of the phonon thermal conductance, it is suggested to use a Schottky diode rectifier between, say, a soft metal and a hard semiconductor, to reduce the phonon thermal conductance via acoustic impedance mismatch. The phonon conductance is independent of the applied voltage, so that larger values of the latter are favorable also from that respect.

The invention is based on the use of the directional motion of charge carriers in a rectifier to transfer heat from a cold terminal to a hot one, and thereby achieve cooling of the former. In order to achieve this, a bias voltage is introduced, and work is invested in the cooling process. The efficiency and the power of this novel thermoelectric system in the ideal case is relatively high, especially for such a simple, available, device. A qualitative experimental proof is given herein below.

We consider a solid-state rectifier, whose typical I-V characteristic is shown in Figure 1. It is idealized, and taken firstly as reverse-biased: all electronic conduction is from the left terminal to the right terminal. But the reverse bias V (a few times $k_B T$, where $k_B$ is the Boltzmann constant and T is the temperature) tries to send electrons to the left. Now, even if the LHS (RHS) is kept at temperatures Tc(Th) where Tc < Th, the device transfers heat between the cool left terminal and the warmer right one; i.e. a (thermoelectric) refrigerator is obtained. That heat per transported electron is given in the ideal case roughly by $W_F$ (the barrier experienced by the electron to go from the left to the right). The energy to cross the barrier is taken from the heat bath on the side the electron comes from (and, basically, delivered to the other side). Thus, the cooling power is $IW_F$ and the invested power is IV, where I is the current. Therefore, the efficiency and power are

$$\eta = W_F / (qV), \qquad\qquad P = IW_F, \qquad\qquad (1)$$

neglecting the "parasitic" phonon thermal conduction back from right to left and taking the energy price per transferred electron against the bias as qV (q is the electron charge). We remark that this is not a linear response (small V and $T_h - T_c$) calculation. It is valid for finite, possibly large, driving forces.

The explanation of why one can take the energy price for transferring one electron against the voltage as V is not trivial. It relies on the fact that a thermodynamic cycle is needed, i.e. restore the system to its initial state. The price for that is qV per electron.

By essentially reversing the process (i.e., employing temperature differences to generate electrical energy) one may use this device for energy harvesting as well.

The difficulty of the above arrangement is in that the barrier for forward motion may increase with the reverse bias. Here the arrangement of the next section will help.

### *Cooling at (large) forward bias*

In one embodiment, this invention provides cooling system and device based on diode operation at forward bias. The following arrangement alleviates the difficulty mentioned above, and the power produced is larger. Accordingly, this method is preferable in one embodiment. Imagine now the same situation as that of Figure 2, except that the bias, V, is reversed and sends electrons from the cool n-side to the warm p-side. The opposite motion is prohibited by the rectifying property and/or by the bias, if taken large. Denoting again the forward barrier between p and n by $W_F$, each transported electron takes about $W_F$ from the left and delivers it to the right. Thus, the efficiency is $\eta = W_F / V$. The cooling power is $P_F = I_F W_F$, similar to the reverse-bias case.

For $W_F \approx 0.5$ V and $I_F \approx 10$ A we get ~ 5W. This is comparable to current Peltier elements. If the voltage is ~ 2V the efficiency is about 0.25 for a barrier of 0.5 V. Obviously, the efficiency decreases with increasing power, as it should.

At low temperatures, activation above the barrier is replaced by elastic (horizontal in Figure 2) tunneling through the barrier and the cooling power per electron loses the large energy factor $W_F$ (replaced by an energy of order $k_B T$). However, it may gain a Carnot efficiency $\eta_c = T_c / T_h - T_c$.

### *Systems and methods for cooling (and heating)*

In one embodiment, this invention provides a system, the system comprising:

- a diode comprising a cathode and an anode;
- a first thermometer attached to said cathode or to said anode; and
- a power supply or a current generator; wherein:
- said power supply or said current generator is connected to leads, said leads provide current/voltage to said diode; said diode is operated under either reverse or forward bias;

wherein said system further comprising a controller configured to:

- receive a desired temperature value for said cathode or for said anode;
- receive a measured temperature value from said thermometer for said cathode or for said anode;
- determine a voltage/current level to be applied to the diode based on the difference between said measured temperature and said desired temperature value; and
- apply said determined voltage/current.

In one embodiment, the diode is a Schottky diode or a PN junction.

In one embodiment, the cathode, anode or a combination thereof are in contact with an element.

In one embodiment, the element is a device, a reservoir, a tube, a wire, a surface, an electrical component, a system or any combination thereof.

In one embodiment, the contact enables heating or cooling of said element by said cathode, said anode or a combination thereof.

In one embodiment, the thermometer comprises a thermocouple.

In one embodiment, this invention provides a method of changing the temperature of an element, said method comprising:

- providing a system comprising:

- a diode comprising a cathode and an anode;
- a first thermometer attached to said cathode or to said anode; and
- a power supply or a current generator; wherein:

  - said power supply or said current generator is connected to leads, said leads provide current/voltage to said diode;
  - said diode is operated under either reverse or forward bias;
  - contacting said cathode or said anode to said element;
  - driving current through or applying voltage to said diode, thereby transferring heat between said element and said diode, thus changing the temperature of said element, wherein said system further comprising a controller configured to:

    - receive a desired temperature value for said cathode or for said anode;
    - receive a measured temperature value from said first thermometer for said cathode or for said anode;
    - determine a voltage/current level to be applied to the diode based on the difference between said measured temperature and said desired temperature value; and
    - apply said determined voltage/current.

In one embodiment, the method further comprises a second thermometer such that: said first thermometer is attached to said cathode and said second thermometer is attached to said anode; or the first thermometer is attached to said anode and said second thermometer is attached to said cathode.

In one embodiment:

- the temperature change of said cathode is detected by said first thermometer; or
- the temperature change of said anode is detected by said second thermometer; or
- a combination thereof.

In one embodiment, changing the temperature of said element comprises cooling or heating of said element.

In one embodiment, the current or the voltage is driven or applied in one direction or in the opposite direction.

In one embodiment, receiving a desired temperature value for a first end of said diode (or receiving desired voltage/current values across the diode in other embodiments) means to receive the value that a user plans to obtain from the first end of the diode (or from the diode). The controller may receive this value from a user, or from a computer associated or comprised within the controller or a computer or other system connected externally to the controller. Such value can be received according to an algorithm. This value can be changed as needed for the operating systems involved, for example, it can be changes as a function of time and as a function of other parameters related to devices and systems of this invention. The desired value can be received manually or automatically. Any method of receiving such values by the controller, are applicable to devices and methods of this invention.

In one embodiment, the method further comprising contacting said cathode or said anode to a second element.

In one embodiment, the cathode is cooled and said anode is heated.

In one embodiment, the temperature change is controlled by the magnitude of said current or said voltage.

In one embodiment, the temperature change in said cathode, said anode or a combination thereof is controlled by said controller, such that said controller receives input from said thermometer(s) and changes the current through or the voltage applied to said diode according to said input, thus controlling said temperature change.

In one embodiment, a third thermometer is in contact with said element.

In one embodiment, the thermometer comprises a thermocouple.

In one embodiment, the efficiency of the conversion of electrical power to thermal power in the device is up to 1.

In one embodiment, the efficiency of the conversion of electrical power to thermal power in the device is ranging between 0.1 and 0.5.

In one embodiment, the power of the system is up to 10W.

In one embodiment, the thermopower of the device is ranging between $20\mu V/deg$ and $30\ \mu V/deg$. In one embodiment, the expected thermopower of the device is ranging between $200\ \mu V/deg$ and $500\ \mu V/deg$.

In one embodiment, the system is portable.

In one embodiment, in systems of this invention, a voltage is applied to the diode or a current is driven through the diode and such operation leads to cooling of one side of the diode. Accordingly, the diode or one end of it can be used as a cooler (a refrigerator). The other side of the diode is heated and in some cases this feature may be used for heating. In systems of this invention, one end of the diode comprises the cathode and the other end of the diode comprising the anode. If one end is being cooled, the other end is being heated. In some embodiments, the first end of the diode is the cathode and the second end of the diode is the anode. According to this aspect and in one embodiment, when current flows through the diode, the cathode is cooled and the anode is heated. In one embodiment, in a diode comprising a PN junction, the n side is the first side of the diode and the p side is the second side of the diode. In one embodiment, in a Schottky diode, the n side is the first side of the diode and the metal side is the second side of the diode. Other embodiments of the invention may include other configurations of diode components.

In one embodiment, systems of the invention are used as cooling devices/refrigerators with the advantage that no elements for gas compression are needed. Accordingly, systems of this invention are used in settings where conventional refrigerators are not available or are not of practical use. Systems of this invention may be used as refrigerators and such refrigerators/cooling devices find use in military, medical, industrial, consumer, scientific/laboratory, and telecommunications applications. Uses of systems of the invention range from simple food and beverage coolers to complex temperature control systems used in military/space applications.

The thermoelectric coolers of this invention permit lowering the temperature of an object as well as stabilizing the temperature of the object. Such thermoelectric cooler is an active cooling system.

In one embodiment, cooling systems of this invention are used as cold plates, in electronics package cooling, integrated circuit cooling, infrared calibration, infrared detectors, laser diode coolers, microprocessor cooling, night vision equipment, refrigerators and on-board refrigeration systems (airplane, auto) in hotels, for portable/picnic uses and as water and beverage coolers.

To increase efficiency, multiple devices/systems may be used in parallel. According to this aspect and in one embodiment, multiple independent systems, each comprising one diode may be used. In another embodiment, one system comprising multiple diodes connected in series/in parallel may be used.

In one embodiment, heat sinks are used in systems of this invention. In one embodiment, a heat sink is connected to one side e.g. to the anode side of the diode and is used to remove heat from this side e.g. from the anode. Any heat sink may be used in systems of this invention as known to the skilled artisan. For example a radiator, a structure made of metal wires can be used as a heat sink.

Systems of this invention do not require moving parts or circulating liquid as in vapor-compression refrigerators. Accordingly, systems of this invention do not suffer from related problems such as leaks and such as certain component failure. Systems of the invention exhibit long life-time, low maintenance, small size, and geometries that are usage-adaptable.

Systems of this invention comprise electrical connections/terminals that are attached to the diode. In one embodiment, the first side of the diode, e.g. the cathode is attached/connected to one electrical terminal and the second side of the diode, e.g. the anode is attached/connected to another electrical terminal. The terminals are connecting the diodes to a power supply/current generator. In other embodiments, the terminals are connected to other electrical/thermal components.

Other components may be included in systems of the invention, such as heat sink(s), heat-isolation elements, other electrical components, controllers, computerized systems, substrates and support, thermal contacts between the diode and an element to be cooled, system casing, etc.

***Systems and Methods for generating electricity***

In one embodiment, which is not part of the claimed invention, there is a system comprising:

- a diode comprising a first end and a second end;
- a heater or a cooling device attached to at least said first end or said second end of said diode.

In one embodiment, the system further comprises at least one thermometer attached to said first end or said second end of said diode.

In one embodiment, the system further comprises a current/voltage meter.

In one embodiment, the system further comprising a second thermometer attached to said second end of said diode.

In one embodiment, the system further comprising:
a controller configured to:

- receive a desired current/voltage value to be developed by said diode;
- receive from said thermometer(s) a measured temperature values for said first end and said second end of said diode;
- determine a temperature difference between the two ends of said diode needed for achieving the desired current/voltage value to be developed by diode; and
- heat or cool said first or said second end of said diode to achieve said desired current/voltage.

In one embodiment, the system is further connected across a load.

In one embodiment, the system further comprises a current/voltage meter and wherein said current/voltage meter is used to measure the current/voltage developed by the diode thus evaluating if the desired/predetermined current/voltage value has been achieved.

In one embodiment, the diode is a Schottky diode or a PN junction.

In one embodiment, the first end comprises the cathode and said second end comprises the anode of said diode.

In one embodiment, the system further comprising a second thermometer attached to said second end of said diode.

In one embodiment, the thermometer comprises a thermocouple.

In one embodiment, the system is used to charge a battery.

In one embodiment, there is a method of generating electricity, said method comprising:

- providing a system comprising:

  • a diode comprising a first end and a second end;
  • a heater or a cooling device attached to at least the first end or the second end of the diode;

- heating (or cooling) said first end or said second end of said diode, thereby generating electricity by said system.

In one embodiment, the diode is connected across a load.

In one embodiment, the method further comprising:

- providing a system comprising:

  • a diode comprising a first end and a second end;
  • a heater or a cooling device attached to at least said first end or said second end of said diode
  • a thermometer attached to at least said first end or said second end of said diode;
  • a current/voltage meter;
  • a controller configured to:

    • receive a desired/predetermined current/voltage value to be developed by said diode;
    • receive from said thermometer a measured temperature value for said first end or said second end of said diode;
    • determine a required temperature difference between the two ends of said diode needed in order to achieve the desired/predetermined current/voltage value; and

- heat or cool said first or said second end of said diode to achieve said current/voltage thereby generating electricity by said system.

In one embodiment, generating electricity comprises generating current by the diode. In one embodiment, generating electricity comprises generating voltage by the diode.

In one embodiment, the current or the voltage is generated in one direction or in the opposite direction.

In one embodiment, the first end comprises the cathode and said second end comprises the anode of said diode.

In one embodiment, the system used in this method further comprising a second thermometer attached to said second end of said diode.

In one embodiment:

- temperature change of said first end is detected by said first thermometer; or temperature change of said second end is detected by said second thermometer; or
- a combination thereof.

In one embodiment, heating/cooling of said diode generates current or develops a potential such that current flows through said load and/or voltage is applied to said load.

In one embodiment, the first end is cooled and said second end is heated.

In one embodiment, the current/voltage is controlled by the temperature difference.

In one embodiment, the current/voltage developed by said diode is detected or measured by the voltage/current meter, such that the controller receives input from the voltage/current meter and changes the level of heating/cooling of at least one end of diode according to said input, thus controlling said current/voltage.

In one embodiment, the thermometer comprises a thermocouple.

In one embodiment, the efficiency of the conversion of thermal power to electrical power in the device is up to a sizable fraction of the Carnot efficiency, 1-Tc/Th.

In one embodiment, the efficiency of the conversion of thermal power to electrical power in the device is ranging between a few % of the said Carnot efficiency, and a sizable fraction of the Carnot efficiency.

In one embodiment, the power of the system is up to 10W. In one embodiment, the thermopower of the system ranges between X= 50 $\mu$V/deg and Y = 400 $\mu$V/deg.

In one embodiment, the efficiency of the conversion of thermal power to electrical power in the device is ideally up to 0.5 of Carnot.

In one embodiment, the efficiency of the conversion of thermal power to electrical power in the device ranges between 0.2 and 0.5 of Carnot.

In one embodiment, the efficiency of the conversion of thermal power to electrical power in the device is ranging between 0.2 and 1 mV/deg.

In one embodiment, the power of the system is up to 10W.

In one embodiment, the thermopower of the device is ranging between to 0.2 mV/deg and 1mV/deg.

In one embodiment, the system is portable.

Two main modes of use of thermoelectric devices of this invention are:

*Energy harvesting*: in this mode and in one embodiment, a temperature difference is created on the diode by cooling one side of the diode, e.g. the cathode, by heating a second side of the diode, e.g. the anode or by a combination thereof. Such cooling/heating generates electricity (voltage/current).

According to this aspect and in one embodiment, the temperature difference leads to movement of electrons from the cold side, e.g. the cathode to the warm side, e.g. the anode. Such electron movement may be used to generate current through a load that is connected to the diode. The electrons movement may cause a potential difference to develop across the diode. Such potential difference may be applied to a load that is connected to the diode. Accordingly, the diode can be used as a power supply/current generator. In one embodiment, in systems of this invention, one end of the diode comprises the cathode and the other end of the diode comprising the anode. If one end is being cooled (or heated), a temperature difference will develop across the diode. In some embodiments, the first end of the diode is the cathode and the second end of the diode is the anode. According to this aspect and in one embodiment, when the cathode is cooled (and/or) the anode is heated, current may be generated by the diode.

In one embodiment, energy harvesting systems of this invention may include a rechargeable battery and the battery may be charged utilizing a temperature difference across the diode as described above in one embodiment.

*Cooling*: in this mode and in one embodiment, a voltage (or a current) is applied to the diode causing one side to cool and the heat is dumped in the other side of the diode. According to this aspect and in one embodiment, the cathode of the diode is cooled while the anode is heated.

In one embodiment, systems of the invention are used as current generators/power supply systems with the advantage that only a temperature difference is required for operation. Accordingly, systems of this invention may find use in settings where conventional power supplies are not available or are not of practical use. Systems of this invention may find use in military, consumer, environmental, and telecommunications applications. Systems of the invention may replace systems that are battery operated.

The thermoelectric systems of this invention may utilize solar heating for operation.

To increase efficiency, multiple systems may be used in series. According to this aspect and in one embodiment, one system comprising multiple diodes connected in series may be used.

In one embodiment, heat sinks are used in systems of this invention, In one embodiment, a heat sink is connected to one side, e.g. the anode side of the diode and is used to remove heat from the anode. Any heat sink may be used in systems of this invention as known to the skilled artisan. For example heat sink such as a radiator, e.g. as in a car; the metallic mesh as installed at the back of a fridge may be used as a heat sink.

Systems of this invention do not require moving parts or circulating liquid as in vapor-compression refrigerators. Accordingly, systems of this invention do not suffer from related problems such as leaks and such as certain component failure. Systems of the invention exhibit long life-time, low maintenance, small size, and geometries that are usage-adaptable.

Systems of this invention comprise electrical connections/terminals that are attached to the diode. In one embodiment, the cathode is attached/connected to one electrical terminal and the anode is attached/connected to another electrical terminal. The terminals are connecting the diodes to a load in one embodiment.

Other components may be included in systems of the invention, such as heat-isolation elements, heat sink(s), other electrical components, computerized systems, substrates and support, thermal contacts between the diode and the heater/cooling element, system casing, etc.

*Combined Systems*

Systems of the invention are combined in one embodiment. For example, heaters and coolers of the invention and power sources of the invention are implemented in a single system. Such systems comprise a diode, a heating/cooling source and a current/voltage generator. According to this aspect and in one embodiment, such combined system is used as a cooling/heating source upon driving current through or applying voltage to the diode, and in other instances, the system is used as a power supply/current generator upon heating or cooling said diode. The current/voltage generator may include a rechargeable battery and the battery may be charged using a temperature difference across the diode in one embodiment.

### Ranges and values

For a device operating in energy harvesting mode, and in one embodiment, for thermopower S=500 $\mu$V/deg and a temperature difference of 200 degrees, 0.1V was obtained from a single diode element of this invention. However, many elements can be connected in series, to achieve much higher values.

For a device operating in a cooling mode, usually across 5-10 degrees (air conditioner, fridge) 10% of the Carnot efficiency gives efficiency of 3-6. In one embodiment, for cooling, the efficiency is the ratio between the absolute temperature and the temperature difference required for cooling. This value can be larger than 1.

In devices of this invention, unlike other thermoelectric devices, the currents flow perpendicular to the interface between the two portions of the diode (e.g. perpendicular to the cathode/anode interface, perpendicular to the interface between the p block and the n block, perpendicular to the interface between the semiconductor and the metal in a Schottky diode etc.).

In one embodiment, one side of the diode is heated (say by sun, waste from an engine) and electricity is obtained.

In one embodiment, voltage is applied to the diode, resulting in cooling of the colder side of the diode.

### Definitions

Left hand side is denoted LHS and right hand side RHS.

For a device operating in an energy harvesting mode, the thermopower units are usually volts/deg or related units e.g. microvolt ($\mu$V) per degree, millivolt/degree etc.

The efficiency is the output power divided by the input power in some embodiments. The efficiency is the ratio between the power/energy that the device yields and between the power/energy invested in the device.

The thermopower in embodiments of this invention refer to the Seebeck coefficient and is measured in Volts per degree.

In one embodiment, the term "a" or "one" or "an" refers to at least one. In one embodiment the phrase "two or more" may be of any denomination, which will suit a particular purpose. In one embodiment, "about" or "approximately" may comprise a deviance from the indicated term of + 1 %, or in some embodiments, - 1 %, or in some embodiments, $\pm$ 2.5 %, or in some embodiments, $\pm$ 5 %, or in some embodiments, $\pm$ 7.5 %, or in some embodiments, $\pm$ 10 %, or in some embodiments, $\pm$ 15 %, or in some embodiments, $\pm$ 20 %, or in some embodiments, $\pm$ 25 %.

### EXAMPLES

### EXAMPLE 1

### Thermoelectric Device Comprising a Diode

To demonstrate the effect qualitatively, a commercial rectifier diode (Vishay VS-SC275S030S6B) has been used. It was mounted as shown in figure 3. Driving current I through the device led to an easily observable temperature difference $\Delta$T across it, measured with a thermocouple. $\Delta$T grew, very roughly linearly, with I, as shown in Figure 4. The effect existed with both forward and backward bias, with magnitudes that were quite similar. By making similar measurements of the voltage V and the resulting $\Delta$T, the thermopower S was found to be 28 $\mu$V/deg at room temperature.

The expected ideal values are roughly an order of magnitude larger, e.g. -300 $\mu$V/deg. The difference may follow from the device having 10-20 diodes in series, as is likely for a rectifier designed to be used at very large voltages/powers.

### Conclusions

For the two cases (forward and backward bias) considered, the efficiency obtained is quite high. Pushing the voltage down to, say, $W_F$, we get 1 in the ideal case. If the three idealizing factors (vanishing backward currents, unchanged forward currents and phonon heat conductance) decrease the efficiency by a factor of two, a value of 1/2 is still respectable for such a simple device. It is of a similar order of magnitude to the values for current thermoelectric devices having the parameter zT≈1. Of course the usual conundrum between power and efficiency exists.

zT is a dimensionless combination of transport coefficients (conductance times thermopower squared over thermal conductance; The larger zT is the better. Present devices have 1. Best lab value is 1.8. Very large zT will give Carnot efficiency. Getting 1.5-2 easily is highly advantageous.

As far as the negative effect of the phonon thermal conductance, it is suggested to use a Schottky diode rectifier between, say, a soft metal and a hard semiconductor, to reduce the phonon thermal conductance via acoustic impedance mismatch. It is noted that the phonon conductance is independent of the applied voltage, so that larger values of the latter are favorable also from that respect.

**Claims**

1. A system comprising:

   • a diode (3.1) comprising a cathode and an anode;
   • at least one thermometer (3.2) connected to said cathode or connected to said anode; and
   • a power supply (3.6) or a current generator; wherein:

      • said power supply or said current generator is connected to leads (3.3), said leads provide current/voltage to said diode;
      • said diode is operated under either reverse or forward bias;
      • and wherein:

   said system further comprises a controller configured to:

      • receive a desired temperature value for said cathode or for said anode;
      • receive a measured temperature value from said thermometer for said cathode or for said anode;
      • determine a voltage/current level to be applied to the diode based on the measured temperature value in order to achieve said desired temperature value at said cathode or at said anode; and
      • apply said determined voltage/current to said diode.

2. The system of claim 1, wherein said cathode, said anode or a combination thereof are in contact with an element (3.5).

3. The system of claim 2, wherein said element is a device, a reservoir, a tube, a wire, a surface, an electrical component, a system or any combination thereof.

4. The system of claim 2, wherein said contact enables heating or cooling of said element by said cathode, said anode or a combination thereof.

5. A method of changing the temperature of an element, said method comprising:

   ▪ providing a system comprising:

      • a diode (3.1) comprising a cathode and an anode;
      • a first thermometer (3.2) attached to said cathode or to said anode; and
      • a power supply (3.6) or a current generator;

   wherein:

      • said power supply or said current generator is connected to leads (3.3), said leads provide current/voltage to said diode;
      • said diode is operated under either reverse or forward bias;

   ▪ contacting said cathode or said anode to said element;
   ▪ driving current through or applying voltage to said diode, thereby transferring heat between said element and said diode, thus changing the temperature of said element,
   wherein said system further comprising a controller configured to:

• receive a desired temperature value for said cathode or for said anode;
• receive a measured temperature value from said first thermometer for said cathode or for said anode;
• determine a voltage/current level to be applied to the diode based on the difference between said measured temperature and said desired temperature value; and
• apply said determined voltage/current.

6. The method of claim 5, further comprising a second thermometer such that:

• said first thermometer is attached to said cathode and said second thermometer is attached to said anode; or
• said first thermometer is attached to said anode and said second thermometer is attached to said cathode.

7. The method of claim 5, wherein said changing the temperature of said element comprises cooling or heating of said element.

8. The method of claim 5, wherein said current or said voltage is driven or applied in one direction or in the opposite direction.

9. The method of claim 5, further comprising contacting said cathode or said anode to a second element.

10. The method of claim 5, wherein said cathode is cooled and said anode is heated.

11. The method of claim 5, wherein said element's temperature change is controlled by the magnitude of said current or said voltage.

12. The method of claim 11, wherein said temperature change in said cathode, said anode or a combination thereof is controlled by said controller, such that said controller receives input from said thermometer(s) and changes the current through or the voltage applied to said diode according to said input, thus controlling said temperature change.

13. The method of claim 5, wherein a third thermometer is in contact with said element.

14. The method of claim 5, wherein the efficiency of the conversion of electrical power to thermal power in said system is ranging between 0.1 and 0.5 and wherein the power of the system is up to 10W and wherein the thermopower of said system is ranging between 200 $\mu$V/K and 500 $\mu$V/K.

15. The method of claim 5, wherein said system is portable.


**Patentansprüche**

1. System, Folgendes umfassend:

• eine Diode (3.1), die eine Kathode und eine Anode umfasst;
• mindestens ein Thermometer (3.2), das mit der Kathode oder mit der Anode verbunden ist; und
• ein Netzteil (3.6) oder einen Stromgenerator;
wobei

• das Netzteil oder der Stromgenerator mit einer Ableitung (3.3) verbunden ist und die Ableitungen die Diode mit Strom/Spannung versorgen;
• die Diode durch Anlegen entweder einer Sperrvorspannung oder einer Durchlassvorspannung betrieben wird;
• und wobei das System ferner einen Regler umfasst, der dazu konfiguriert ist,

• einen erwünschten Temperaturwert für die Kathode oder für die Anode zu empfangen;
• einen von dem Thermometer gemessenen Temperaturwert für die Kathode oder für die Anode zu empfangen;
• einen Spannungs-/Strompegel zu bestimmen, der basierend auf dem gemessenen Temperaturwert an die Diode anzulegen ist, um den erwünschten Temperaturwert an der Kathode oder an der Anode zu erreichen; und

• Anlegen der bestimmten Spannung/des bestimmten Stroms an die Diode.

2. System nach Anspruch 1, wobei die Kathode, die Anode oder eine Kombination davon mit einem Element (3.5) in Kontakt ist.

3. System nach Anspruch 2, wobei das Element ein Gerät, ein Sammelbehälter, ein Rohr, ein Draht, eine Oberfläche, eine Elektrokomponente, ein System oder eine beliebige Kombination davon ist.

4. System nach Anspruch 2, wobei der Kontakt ein Erhitzen oder ein Kühlen des Elements durch die Kathode, die Anode oder einer Kombination davon ermöglicht.

5. Verfahren zum Ändern der Temperatur eines Elements, wobei das Verfahren Folgendes umfasst:

   • Bereitstellen eines Systems, das Folgendes umfasst:

      • eine Diode (3.1), die eine Kathode und eine Anode umfasst;
      • ein erstes Thermometer (3.2), das an der Kathode oder an der Anode befestigt ist; und
      • ein Netzteil (3.6) oder einen Stromgenerator;
      wobei
      • das Netzteil oder der Stromgenerator mit einer Ableitung (3.3) verbunden ist und die Ableitungen die Diode mit Strom/Spannung versorgen;
      • die Diode entweder bei Sperrvorspannung oder Durchlassvorspannung betrieben wird;

   • Kontaktieren der Kathode oder der Anode mit dem Element;
   • Leiten von Spannung durch die Diode oder Anlegen hieran, wodurch Wärme zwischen dem Element und der Diode übertragen wird, wodurch die Temperatur des Elements verändert wird,
   wobei das System ferner einen Regler umfasst, der folgendermaßen konfiguriert ist, zum

      • Empfangen eines erwünschten Temperaturwerts für die Kathode oder für die Anode;
      • Empfangen eines von dem ersten Thermometer gemessenen Temperaturwerts für die Kathode oder für die Anode;
      • Bestimmen eines Spannungs-/Strompegels, der basierend auf der Differenz der gemessenen Temperatur und des erwünschten Temperaturwerts an die Diode anzulegen ist; und
      • Anlegen der bestimmten Spannung/des bestimmten Stroms.

6. Verfahren nach Anspruch 5, ferner umfassend ein zweites Thermometer, derart dass

   • das erste Thermometer an der Kathode und das zweite Thermometer an der Anode befestigt ist; oder dass
   • das erste Thermometer an der Anode und das zweite Thermometer an der Kathode befestigt ist.

7. Verfahren nach Anspruch 5, wobei das Ändern der Temperatur des Elements ein Kühlen oder ein Erhitzen des Elements umfasst.

8. Verfahren nach Anspruch 5, wobei der Strom oder die Spannung in eine Richtung oder in die entgegengesetzte Richtung geregelt oder angelegt wird.

9. Verfahren nach Anspruch 5, ferner umfassend ein Kontaktieren der Kathode oder der Anode mit einem zweiten Element.

10. Verfahren nach Anspruch 5, wobei die Kathode gekühlt und die Anode erhitzt wird.

11. Verfahren nach Anspruch 5, wobei die Temperaturänderung des Elements von der Maßeinheit des Stroms oder der Spannung geregelt wird.

12. Verfahren nach Anspruch 11, wobei die Temperaturänderung an der Kathode, der Anode oder einer Kombination davon von dem Regler geregelt wird, derart dass der Regler einen Eingang von dem/den Thermometer/n empfängt und den Strom, der durch die Diode fließt, oder die Spannung, die an der Diode angelegt wird, gemäß diesem Eingang ändert, um dadurch die Temperaturänderung zu regeln.

**13.** Verfahren nach Anspruch 5, wobei ein drittes Thermometer mit dem Element in Kontakt ist.

**14.** Verfahren nach Anspruch 5, wobei die Effizienz der Umwandlung der elektrischen Leistung in thermische Leistung in dem System in einem Bereich zwischen 0,1 und 0,5 liegt, und wobei die Leistung des Systems bis zu 10W beträgt, und wobei die thermische Leistung des Systems in einem Bereich zwischen 200 μV/K und 500 μV/K liegt.

**15.** Verfahren nach Anspruch 5, wobei das System tragbar ist.

**Revendications**

**1.** Système comprenant :

- une diode (3.1) comprenant une cathode et une anode ;
- au moins un thermomètre (3.2) connecté à ladite cathode ou connecté à ladite anode ; et
- une alimentation électrique (3.6) ou un générateur de courant ;

dans lequel :

- ladite alimentation électrique ou ledit générateur de courant est connecté aux conducteurs (3.3) lesdits conducteurs fournissant courant/tension à ladite diode ;
- ladite diode fonctionne en polarisation inverse ou directe ;

et dans lequel :
ledit système comprend en outre un contrôleur configuré pour :

- recevoir une valeur de température souhaitée pour ladite cathode ou pour ladite anode ;
- recevoir une valeur de température mesurée dudit thermomètre pour ladite cathode ou pour ladite anode ;
- déterminer un niveau de tension/courant à appliquer à la diode en fonction de la valeur de température mesurée afin d'atteindre ladite valeur de température souhaitée au niveau de ladite cathode ou de ladite anode ; et
- appliquer ladite tension/ledit courant déterminé à ladite diode.

**2.** Système selon la revendication 1, dans lequel ladite cathode, ladite anode ou une combinaison de celles-ci sont en contact avec un élément (3.5).

**3.** Système selon la revendication 2, dans lequel ledit élément est un dispositif, un réservoir, un tube, un fil électrique, une surface, un composant électrique, un système ou toute combinaison de ceux-ci.

**4.** Système selon la revendication 2, dans lequel ledit contact permet de chauffer ou de refroidir ledit élément par ladite cathode, ladite anode ou une combinaison de celles-ci.

**5.** Procédé de modification de la température d'un élément, ledit procédé consistant à :

- fournir un système comprenant :

  - une diode (3.1) comprenant une cathode et une anode ;
  - un premier thermomètre (3.2) fixé à ladite cathode ou à ladite anode ; et
  - une alimentation électrique (3.6) ou un générateur de courant ;

  dans lequel :

  - ladite alimentation électrique ou ledit générateur de courant est connecté aux conducteurs (3.3), lesdits conducteurs fournissant courant/tension à ladite diode ;
  - ladite diode fonctionne en polarisation inverse ou directe ;

- mettre en contact ladite cathode ou ladite anode avec ledit élément ;
- faire passer un courant à travers ou appliquer une tension à ladite diode, transférant ainsi de la chaleur entre ledit élément et ladite diode, changeant ainsi la température dudit élément ;

dans lequel ledit système comprend en outre un contrôleur configuré pour :

- recevoir une valeur de température souhaitée pour ladite cathode ou pour ladite anode ;
- recevoir une valeur de température mesurée dudit premier thermomètre pour ladite cathode ou pour ladite anode;
- déterminer un niveau de tension/courant à appliquer à la diode en fonction de la différence entre ladite température mesurée et ladite valeur de température souhaitée ; et
- appliquer ladite tension/courant déterminé.

6. Procédé selon la revendication 5, comprenant en outre un deuxième thermomètre de sorte que :

- ledit premier thermomètre est fixé à ladite cathode et ledit deuxième thermomètre est fixé à ladite anode ; ou
- ledit premier thermomètre est fixé à ladite anode et ledit deuxième thermomètre est fixé à ladite cathode.

7. Procédé selon la revendication 5, dans lequel ledit changement de température dudit élément comprend le refroidissement ou le chauffage dudit élément.

8. Procédé selon la revendication 5, dans lequel ledit courant ou ladite tension est amené ou appliqué dans un sens donné ou dans le sens opposé.

9. Procédé selon la revendication 5, comprenant en outre la mise en contact de ladite cathode ou de ladite anode avec un deuxième élément.

10. Procédé selon la revendication 5, dans lequel ladite cathode est refroidie et ladite anode est chauffée.

11. Procédé selon la revendication 5, dans lequel ledit changement de température dudit élément est contrôlé par l'amplitude dudit courant ou de ladite tension.

12. Procédé selon la revendication 11, dans lequel ledit changement de température dans ladite cathode, ladite anode ou une combinaison de celles-ci est contrôlé par ledit contrôleur, de sorte que ledit contrôleur reçoit une donnée dudit ou desdits thermomètres et change le courant traversant ou la tension appliquée à ladite diode selon ladite donnée, contrôlant ainsi ledit changement de température.

13. Procédé selon la revendication 5, dans lequel un troisième thermomètre est en contact avec ledit élément.

14. Procédé selon la revendication 5, dans lequel le rendement de la conversion de l'énergie électrique en énergie thermique dans ledit système est compris entre 0,1 et 0,5 et dans lequel la puissance du système atteint jusqu'à 10W et dans lequel la puissance thermique dudit système est comprise entre 200 $\mu$V/K et 500 $\mu$V/K.

15. Procédé selon la revendication 5, dans lequel ledit système est portable.

Figure 1

Figure 2

**Figure 3**

**Figure 4**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 101504439
- CN 202581241 U
- KR 20140127056
- US 20030218464 A

**Non-patent literature cited in the description**

- **PIPE K.P. et al.** *Phys. Rev. B.,* 11 January 2002, vol. 66, 125316